(19)

Europäisches
Patentamt
European
Patent Office
Office européen
des brevets

(11) **EP 4 718 716 A2**

(12) **EUROPEAN PATENT APPLICATION**

(43) Date of publication:
**01.04.2026 Bulletin 2026/14**

(21) Application number: 25188484.7

(22) Date of filing: **09.07.2025**

(51) International Patent Classification (IPC):
*H03F 3/00* (2006.01)   *H03F 3/195* (2006.01)
*H03F 3/21* (2006.01)   *H03F 3/213* (2006.01)
*H03F 3/217* (2006.01)   *H03F 3/24* (2006.01)
*H03F 1/32* (2006.01)

(52) Cooperative Patent Classification (CPC):
**H03F 3/245; H03F 1/3205; H03F 3/005;**
**H03F 3/195; H03F 3/211; H03F 3/213;**
**H03F 3/2178;** H03F 2200/09; H03F 2200/48

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **26.09.2024 AU 2024903101**

(71) Applicant: **Morse Micro Pty. Ltd.**
**Surry Hills, NSW 2010 (AU)**

(72) Inventors:
• Penfold, Justin
  Surry Hills NSW, 2010 (AU)
• Hiller, Alex
  Surry Hills NSW, 2010 (AU)
• Meesaraganda, Surendra Raju
  Surry Hills NSW, 2010 (AU)

(74) Representative: **MERH-IP Matias Erny Reichl**
**Hoffmann**
**Patentanwälte PartG mbB**
**Paul-Heyse-Straße 29**
**80336 München (DE)**

(54)   **DIGITAL POWER AMPLIFIER WITH ANALOG CLIPPING SCHEME**

(57)   Described are techniques for analog clipping for a switched capacitor power amplifier comprising an array of a plurality of unit cells shareable between in-phase (I) and quadrature-phase (Q) signal components. A pair of control bits is associated with each unit cell, comprising a first control bit to selectively enabling the unit cell to use the I component, and a second control bit to selectively enabling the unit cell to use the Q component. A truth table is configured for a first subset and a second subset of unit cells, and causes the unit cells of the first subset to be driven by the I component in response to a double-enabled condition of the respective pair of control bits. The truth table is configured to cause the unit cells of the second subset to be driven by the Q component in response to the double-enabled condition.

100

**FIG. 1**

**Description**

CROSS-REFERENCE TO RELATED APPLICATIONS

This application claims the benefit of Australian Provisional Patent Application No. 2024903101, filed September 26, 2024, which is hereby incorporated by reference, in its entirety and for all purposes.

FIELD

The present disclosure generally relates to wireless communications. For example, aspects of the present disclosure are related to clipping schemes for a digital power amplifier and/or switched capacitor power amplifier, where the clipping may be implemented locally for the output units of a capacitor array included in the amplifier.

BACKGROUND

Power Amplifiers (PAs) are used in Radio Frequency (RF) transmitters for transmission of electromagnetic energy. Power amplifier efficiency highly influences power consumption in wireless transceivers, as the PA may represent a significant portion of the power consumed by a radio system. A PA receives a direct current (DC) power supply input, and provides an RF power output. The efficiency of the power conversion from the DC supply input to the RF power output directly corresponds to the overall efficiency of the PA. Improving the PA efficiency, or efficiency of power conversion from DC input to RF output, can conserve energy and extend the battery life of the various mobile and/or wireless devices that use PAs. PAs are generally designed to achieve a maximum power efficiency while the PA is operating at maximum output power. The power efficiency of a PA may reduce significantly when the PA operates in various reduced output power regimes that are below the maximum output power.

Recently, Digital Power Amplifiers (DPAs) have seen growing interest, as a DPA can integrate multiple functions and/or functionalities, such as a Digital to Analog Converter (DAC), a frequency up-converter/mixer, and a PA. The use of a DPA in an RF transceiver can improve the energy efficiency and reduce the power consumption of the RF transceiver, and can additionally reduce the chip area associated with the physical implementation of the RF transceiver (e.g., based on the multiple functions integrated into or by the DPA). A 'high power' DPA can be associated with a relatively high power consumption, and may employ various techniques to optimize efficiency. However, the efficiency optimization(s) used by existing high power DPAs may also introduce distortion, particularly when the input amplitude codes driving the DAC (e.g., the DAC included or integrated within the DPA) are large. In-phase (I) and Quadrature-phase (Q) components of an input signal may be separated and coupled to different sections of the DPA. Coding circuits within the DPA are used for mapping the respective amplitudes of the I and Q components to drive these separate sections of the DPA. The signals from each section are then summed (e.g., recombined) to generate the final output of the DPA. A Switched capacitor Power amplifier (ScPa) is a type of DPA, which uses capacitors, along with transistors acting as switches, to achieve high linearity and efficiency, especially at higher output power levels. In an ScPa architecture, capacitors in arrays may be selectively driven (or not driven) by an input clock signal, to thereby be turned on or off. This selective activation of capacitors can be controlled by amplitude codes derived from the amplitudes of the I and Q components of the input signal. For example, the amplitudes of the I and Q components can be coded into amplitude codes, and used to control which capacitors in each capacitor array of the ScPa are turned on.

BRIEF SUMMARY

The following presents a simplified summary relating to one or more aspects disclosed herein. Thus, the following summary should not be considered an extensive overview relating to all contemplated aspects, nor should the following summary be considered to identify key or critical elements relating to all contemplated aspects or to delineate the scope associated with any particular aspect. Accordingly, the following summary has the sole purpose to present certain concepts relating to one or more aspects relating to the mechanisms disclosed herein in a simplified form to precede the detailed description presented below.

Disclosed are systems, methods, apparatuses, and computer-readable media for digital power amplifiers with analog clipping schemes. In an illustrative example, provided is a switched capacitor power amplifier (ScPa) apparatus comprising: a switched capacitor array including a plurality of unit cells shareable between an in-phase (I) component and a quadrature-phase (Q) component of an input radio frequency (RF) signal, wherein each unit cell of the plurality of unit cells comprises a capacitor and an inverter; a respective pair of control bits associated with each unit cell of the plurality of unit cells, wherein the respective pair of control bits includes a first control bit configured for selectively enabling or not enabling the unit cell to be driven based on the I component, and a second control bit configured for selectively enabling or not enabling the unit cell to be driven based on the Q component; and a truth table logic configured for a first subset and a second subset of unit cells of the plurality of unit cells, wherein the truth table logic causes the unit cells of the first subset to be driven based on the I component in response to a double-enabled condition of the respective pair of control bits, and wherein the truth table logic causes the unit cells of the second subset to be driven based on the Q component in response to the double-enabled condition of the respective pair of control bits

In some aspects, the ScPa apparatus implements an analog clipping scheme based on a set of unit cells with the double-enabled condition of the switched capacitor array configured with the truth table logic, wherein the set of unit cells with the double-enabled condition is included in the plurality of unit cells.

In some aspects, the analog clipping scheme implemented using the truth table logic causes a first half of the set of unit cells with the double-enabled condition to be driven by an I clock corresponding to the I component, and causes a second half of the set of unit cells with the double-enabled condition to be driven by a Q clock corresponding to the Q component.

In some aspects, the set of unit cells with the double-enabled condition is equal to a difference between a magnitude of the I component summed with a magnitude of the Q component, and a number of the plurality of unit cells included in the switched capacitor array.

In some aspects, the double-enabled condition corresponds to each bit of the respective pair of control bits for a unit cell being set to high, indicative of enabling the unit cell to be driven based on the I component and enabling the unit cell to be driven based on the Q component.

In some aspects, the first subset of unit cells comprises a first half of the plurality of unit cells, and wherein the second subset of unit cells comprises a second half of the plurality of unit cells.

In some aspects, a number of unit cells included in the first subset is equal to a number of unit cells included in the second subset.

In some aspects, the first subset of unit cells comprises even-indexed unit cells of the switched capacitor array, and wherein the second subset of unit cells comprises odd-indexed unit cells of the switched capacitor array.

Alternatively, the first subset of unit cells comprises odd-indexed unit cells of the switched capacitor array, and wherein the second subset of unit cells comprises even-indexed unit cells of the switched capacitor array.

In some aspects, one of the first subset and the second subset of unit cells comprises even-indexed unit cells of the switched capacitor array, and another one of the first subset and the second subset of unit cells comprises odd-indexed unit cells of the switched capacitor array.

In some aspects, the truth table logic causes the plurality of unit cells to be driven according to the respective pair of control bits in the absence of the double-enabled condition.

In some aspects, the truth table logic encodes a priority of the I component over the Q component for the first subset of unit cells, wherein the truth table logic maps the encoded priority of the I component over the Q component to the double-enabled condition where the first and second control bits are each set high for a respective unit cell of the first subset.

In some aspects, the truth table logic encodes a priority of the Q component over the I component for the second subset of unit cells, wherein the truth table logic maps the encoded priority of the Q component over the I component to the double-enabled condition where the first and second control bits are each set high for a respective unit cell of the second subset of unit cells.

In some aspects, each unit cell of the plurality of unit cells of the switched capacitor array is switchably coupled to a primary input of an inductive transformer or balun included in the ScPa apparatus.

In some aspects, the truth table logic causes the ScPa apparatus to automatically implement an analog clipping scheme for IQ amplitude codes having a magnitude sum greater than a number of unit cells included in the plurality of unit cells; and the analog clipping scheme is implemented locally by each unit cell with the double-enabled condition, according to the configured truth table logic for each unit cell with the double-enabled condition.

In some aspects, the ScPa apparatus further comprises a voltage level shifter in an output switch unit, wherein the output switch unit comprises an NMOS switch device gate, an NMOS cascode gate, a PMOS cascode gate, and a PMOS switch device gate.

In some aspects, the NMOS switch device gate is driven from a core voltage inverter driven from a core voltage (VDDL) rail, the NMOS cascode gate is coupled to the VDDL rail, the PMOS cascode gate is biased at a fixed voltage below an IO voltage (VDDH) rail, and the PMOS switch device gate is charged with a voltage of (VDDH - VDDL) by signal voltage shifting using a capacitor between the NMOS switch device gate and the PMOS switch device gate.

In some aspects, the IO voltage (VDDH) is set to be a maximum of twice the core voltage (VDDL).

In some aspects, the output switch unit further comprises a cross coupled PMOS device to periodically top up any small amount of charge leaks away from the capacitor over time.

In some aspects, the PMOS cascode gate is coupled to a charge pump driven by VDDL level clock inputs, and a core supply voltage of the charge pump is DC-shifted through series capacitors to generate a rail that is one core voltage below the VDDH rail.

In another illustrative example, provided is a method of controlling a switched capacitor power amplifier (ScPa) with adaptive clipping, the method comprising: obtaining in-phase (I) and quadrature-phase (Q) codes corresponding to an input radio frequency (RF) signal; comparing a sum of absolute values of the I and Q codes with a threshold value, the threshold value corresponding to a number of unit cells included in a plurality of unit cells of a switched capacitor array of the ScPa; determining each output cell of inverter and capacitor arrays in the ScPa to be an I clock enabled output cell, a Q clock enabled output cell, a double-enabled output cells, or an off output cell according to the I and Q codes, wherein the number of double-enabled output cells is equal to zero when the sum of absolute values of the I and Q codes is less than or equal to the threshold value, and the number of double-enabled output cells is equal to the sum of absolute values of the I and Q codes minus the threshold value; controlling a half of the double-enabled output cell to be driven by an I clock and controlling another half of the double-enabled output cell to be driven by a Q clock; controlling the I clock enabled output cells of the inverter and capacitor arrays to be driven by the I clock; and controlling the Q clock enabled output cells of the inverter and capacitor arrays to be driven by the Q clock.

In some aspects, controlling the ScPa includes implementing an analog clipping scheme based on configuring a set of unit cells with a double-enabled condition of the switched capacitor array with a truth table logic, wherein the set of unit cells with the double-enabled condition is included in the plurality of unit cells.

In some aspects, the truth table logic causes a first half of the set of unit cells with the double-enabled condition to be driven by an I clock corresponding to the I code, and causes a second half of the set of unit cells with the double-enabled condition to be driven by a Q clock corresponding to the Q code.

Other objects and advantages associated with the aspects disclosed herein will be apparent to those skilled in the art based on the accompanying drawings and detailed description.

BRIEF DESCRIPTION OF THE DRAWINGS

Illustrative aspects of the present application are described in detail below with reference to the following drawing figures:

FIG. 1 is a block diagram illustrating an exemplary wireless communication network;

FIG. 2A is a block diagram of a wireless communication device that can implement a station (STA) or access point (AP), in accordance with some embodiments;

FIG. 2B is a schematic block diagram of the receiver data flow architecture of the wireless communication device of FIG. 2A, in accordance with some embodiments;

FIG. 2C is a schematic block diagram of a transmitter data flow architecture that can be used to transmit Radio Frequency (RF) signals over a wireless medium, in accordance with some embodiments;

FIG. 3 illustrates an example of a digitally-controlled Switched-capacitor Power amplifier (ScPa) architecture configured with two arrays of CMOS inverters, where each array includes a plurality of capacitors which are either driven or not driven by a corresponding inverter within the array, in accordance with some embodiments;

FIG. 4 is a diagram illustrating an example of a combined driving scheme for an ScPa architecture implemented using a non-Cartesian system, in accordance with some embodiments;

FIG. 5 is a diagram illustrating an example of a combined driving scheme for an ScPa architecture implemented using a Cartesian system, in accordance with some embodiments;

FIG. 6 is a diagram illustrating an example of a combined driving scheme for an ScPa architecture implemented using a Cartesian system and four branches of inverter and capacitor arrays, in accordance with some embodiments;

FIG. 7 is an IQ constellation diagram illustrating a clipping rhombus corresponding to a performance degradation threshold for a digital power amplifier, in accordance with some embodiments;

FIG. 8 is a diagram illustrating an example of a capacitor array unit (e.g., an output cell) allocation when clipping is not required for an IQ shared cell ScPa, and an example of a capacitor array unit allocation when clipping is required for the IQ shared cell ScPa, in accordance with some embodiments;

FIG. 9 depicts an example schematic of an example ScPa output switch unit including a stack of four core devices comprising two switch devices and two cascode devices, in accordance with some embodiments;

FIG. 10 illustrates an example of a circuit that achieves the required voltage on each of the devices included in the stack of the four core devices in the ScPa output unit of FIG. 9, in accordance with some embodiments;

FIG. 11 illustrates an example of a circuit with a charge pump driven by VDDL level clock inputs, in accordance with some embodiments; and

FIG. 12 is a block diagram illustrating an example of a computing system for implementing certain aspects described herein, in accordance with some embodiments.

DETAILED DESCRIPTION

Certain aspects of this disclosure are provided below. Some of these aspects may be applied independently and some of them may be applied in combination as would be apparent to those of skill in the art. In the following description, for the purposes of explanation, specific details are set forth in order to provide a thorough understanding of aspects of the application. However, it will be apparent that various aspects may be practiced without these specific details. The figures and description are not intended to be restrictive.

The ensuing description provides example aspects only, and is not intended to limit the scope, applicability, or configuration of the disclosure. Rather, the ensuing description of the example aspects will provide those skilled in the art with an enabling description for implementing an example aspect. It should be understood that various changes may be made in the function and arrangement of elements without departing from the spirit and scope of the application as set forth in the appended claims.

OVERVIEW

Aspects of the present invention can be used to provide novel and effective techniques of power amplifier clipping to reduce and/or minimize distortion or other performance degradation that may be associated with driving the power amplifier beyond a configured output level or other operating region. In some embodiments, the systems and techniques described herein can be used to implement improved efficiency PAs based on combining outputs from two or more separate PAs, where the separate PAs are operated for different regions or values of an input signal or signal component. In one illustrative example, switched capacitor power amplifiers (ScPas) are used to address challenges and problems that may otherwise be associated with the use of a digital-to-analog (DAC), as ScPas are fully digital power amplifiers. Aspects of the disclosure include implementations where the ScPas are provided in combination with integrated Complementary Metal-Oxide-Semiconductor (CMOS) systems.

Aspects and embodiments of the invention correspond to providing a digitally controlled ScPa system for power amplification with improved power efficiency. For example, the digitally controlled ScPa system can combine the outputs of two separate ScPas, based at least in part on the output impedance of an ScPa being observed to be constant across all gain settings. Advantageously, embodiments of the present disclosure can be implemented by configuring and/or reconfiguring components already present within an ScPa to obtain the combiner for combining the outputs of the two separate PAs. As such, the improved efficiency digitally controlled ScPa system described herein may be implemented without a requirement to add additional large and/or complicated physical circuitry, etc. In some embodiments, aspects of the disclosure include the ability, when operating in a Cartesian system, to configure the amplifier controls to combine In-phase (I) and Quadrature-phase (Q) signals without experiencing the degradation in efficiency that is normally associated with an integrated mixer. Further still, the systems and techniques can be used to provide a modification to the combiner arrangement that can maximize power efficiency at multiple back-off levels, including maximizing efficiency at a 12dB back-off as well as maximizing efficiency at a 6dB back-off.

EXAMPLE EMBODIMENTS

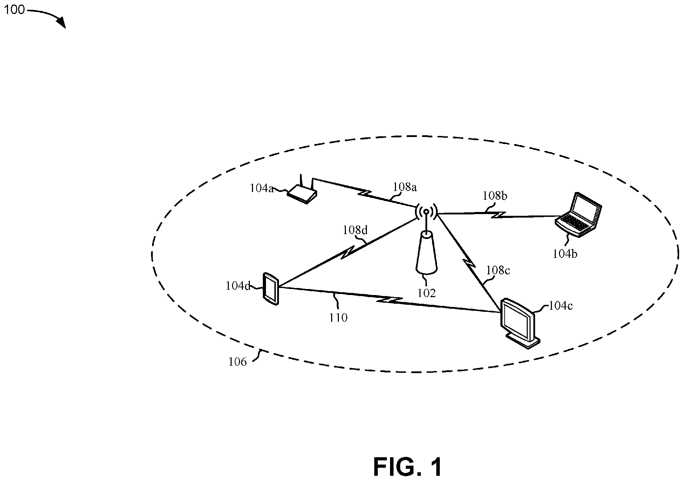

FIG. 1 is a block diagram illustrating an exemplary wireless communication network 100. In some aspects, the wireless communication network 100 can be an example of a Wireless Local Area Network (WLAN). As used herein, a WLAN may be a Wi-Fi network. In some examples, the WLAN 100 can be a network implementing at least one of the IEEE 802.11 family of wireless communication protocol standards (e.g., such as that defined by the IEEE 802.11-2020 specification or amendments thereof including, but not limited to, 802.11ah, 802.11ay, 802.11 ax, 802.11az, 802.11ba and 802.11be). The WLAN 100 may include at least one AP 102 and multiple associated STAs 104. For example, the STAs 104 can include a first STA 104a, a second STA 104b, a third STA 104c, a fourth STA 104d, etc. While only one AP 102 is shown, the WLAN network 100 also can include multiple APs 102.

Each of the STAs 104a-104d may be referred to as a Mobile Station (MS), a mobile device, a mobile handset, a wireless handset, an Access Terminal (AT), a User Equipment (UE), a Subscriber Station (SS), and/or a subscriber unit, among other examples. The STAs 104 may represent various devices such as mobile phones, handheld devices, netbooks, computers, tablet computers, laptops, display devices (e.g., TVs, computer monitors, navigation systems, etc.), music or other audio or stereo devices, remote control devices ("remotes"), printers, kitchen or other household appliances, key fobs (e.g., for Passive Keyless Entry and Start (PKES) systems), etc.

A single AP 102 and an associated set of STAs 104a-104d may be referred to as a Basic Service Set (BSS), which is managed by the respective AP 102. FIG. 1 additionally shows an example coverage area 106 of the AP 102, which may represent a Basic Service Area (BSA) of the WLAN 100. The BSS may be identified to users by a Service Set Identifier (SSID), as well as to other devices by a Basic Service Set Identifier (BSSID), which may be a Medium Access Control (MAC) address of the AP 102.

The AP 102 periodically broadcasts beacon frames ("beacons") including the BSSID to enable any STAs (e.g., such as one or more, or all, of the STAs 104a-104d) within wireless range of the AP 102 to associate or re-associate with the AP 102 to establish a respective communication link 108a-108d (e.g., hereinafter also referred to as a "Wi-Fi link"). For example, the first STA 104a can establish a respective communication link 108a with the AP 102, the second STA 104b can establish a respective communication link 108b with the AP 102, the third STA 104c can establish a respective communication link 108c with the AP 102, the fourth STA 104d can establish a respective communication link 108d with the AP 102, etc. The STAs 104a-104d may additionally use the beacon frames broadcast by AP 102 to maintain the respective communication link 108a-108d with the AP 102. For example, the beacons can include an identification of a primary channel used by the respective AP 102 as well as a timing synchronization function for establishing or maintaining timing synchronization with the AP 102. The AP 102 may provide access to external networks to various STAs in the WLAN via respective communication links 108.

To establish the communication links 108a-108d with an AP 102, each of the respective STAs 104a-104d can perform passive or active scanning operations ("scans") on frequency channels in one or more frequency bands. For example, to perform passive scanning, each of the STAs 104a-104d listens for beacons that are transmitted by the AP 102 at a periodic time interval referred to as the Target Beacon Transmission Time (TBTT). The TBTT can be measured in Time Units (TUs). In some examples, one TU may be equal to 1024 microseconds ($\mu$s). In some examples, the TBTT can have a default value of 102.4 milliseconds (ms). To perform active scanning, each of the STAs 104a-104d can generate and sequentially transmit probe requests on each channel to be scanned and listens for probe responses from the AP 102. Each of the STAs 104a-104d may be configured to identify or select an AP 102 with which to associate (e.g., based on the scanning information obtained through the passive or active scans), and to perform authentication and association operations to establish a respective communication link 108a-108d with the selected AP 102. The AP 102 assigns an Association Identifier (AID) to each of the STAs 104a-104d at the culmination of the association operations, which the AP 102 uses to track the STAs 104a-104d.

In some cases, one or more of the STAs 104a-104d may have the opportunity to select one of many BSSs within range of the STA or to select among multiple APs 102 that together form an Extended Service Set (ESS) including multiple connected BSSs. An extended network station associated with the WLAN 100 may be connected to a wired or wireless distribution system that may allow multiple APs 102 to be connected in an ESS. In some examples, one or more of the STAs 104a-104d can be covered by more than one AP 102 and can associate with different APs 102 at different times for transmissions. After association with an AP 102, one or more of the STAs 104a-104d also may be configured to periodically scan its surroundings to find a more suitable AP with which to associate. For example, a given one of the STAs 104a-104d that is moving away from its associated AP 102 may perform a "roaming" scan to find another AP having more desirable network characteristics (e.g., such as a greater Received Signal Strength Indicator (RSSI), a reduced traffic load, etc.).

In some cases, the STAs 104a-104d may form networks without APs 102 or other equipment other than the STAs 104a-104d themselves. One example of such a network is an ad hoc network. Some examples of an ad hoc network are mesh networks and peer-to-peer (P2P) networks. In some cases, ad hoc networks may be implemented within a larger wireless network In such implementations, while the STAs 104a-104d may be capable of communicating with each other through the AP 102 using the respective communication links 108a-108d, the STAs 104a-104d, the STAs may also communicate directly with each other using direct wireless links 110. In some examples, two STAs may communicate via a direct communication link 110 regardless of whether both STAs 104 are associated with and served by the same AP 102. In such an ad hoc system, one or more of the STAs 104a-104d may assume the role filled by the AP 102 in a BSS. Such a STA may be referred to as a Group Owner (GO) and may coordinate transmissions within the ad hoc network. Examples of direct wireless links 110 can include one or more of Wi-Fi Direct connections, connections established by using a Wi-Fi Tunneled Direct Link Setup (TDLS) link, and other P2P group connections, etc.

The APs 102 and STAs 104a-104d may function and communicate using the respective communication links 108a-108d according to at least one of the IEEE 802.11 wireless communication protocol standards. These standards define the WLAN radio and baseband protocols for the physical (PHY) and Medium Access Control (MAC) layers. For example, the APs 102 and STAs 104a-104d transmit and receive wireless communications to and from one another in the form of PHY Protocol Data Units (PPDUs) or Physical Layer Convergence Protocol (PLCP) PDUs. The APs 102 and STAs 104a-104d in the WLAN 100 may transmit PPDUs over a license or unlicensed spectrum, which may be a portion of spectrum that includes frequency bands traditionally used by Wi-Fi technology, such as the 2.4 GHz band, the 5 GHz band, the 60 GHz band, the 3.6 GHz band, and the sub-1 GHz band. Some implementations of the APs 102 and STAs 104a-104d described herein also may communicate in other frequency bands, such as the 6 GHz band, which may support both licensed and unlicensed communications. The APs 102 and STAs 104a-104d also can be configured to communicate over other frequency bands such as shared licensed frequency bands, where multiple operators may have a license to operate in the same or overlapping frequency band or bands.

Each of the frequency bands may include multiple sub-bands or frequency channels. For example, PPDUs conforming to the IEEE 802.11 standards and specifications may be transmitted over frequency bands that are divided into multiple 20 MHz channels. In such examples, the PPDUs are transmitted over a physical channel having a minimum bandwidth of 20 MHz, although other channel bandwidths are also possible. In some cases, a larger bandwidth channel can be formed using channel bonding, which bonds together multiple channels each of the minimum bandwidth.

Each PPDU is a composite structure that includes a PHY preamble and a payload in the form of a PHY Service Data Unit (PSDU). The information provided in the preamble may be used by a receiving device to decode the subsequent data in the PSDU. In instances in which PPDUs are transmitted over a bonded channel, the preamble fields may be duplicated and transmitted in each of the multiple component channels. The PHY preamble may include both a legacy portion (or "legacy preamble") and a non-legacy portion (or "non-legacy preamble"). The legacy preamble may be used for packet detection, automatic gain control and channel estimation, among other uses. The legacy preamble also may generally be used to maintain compatibility with legacy devices. The format of, coding of, and information provided in the non-legacy portion of the preamble is based on the particular IEEE 802.11 protocol to be used to transmit the payload.

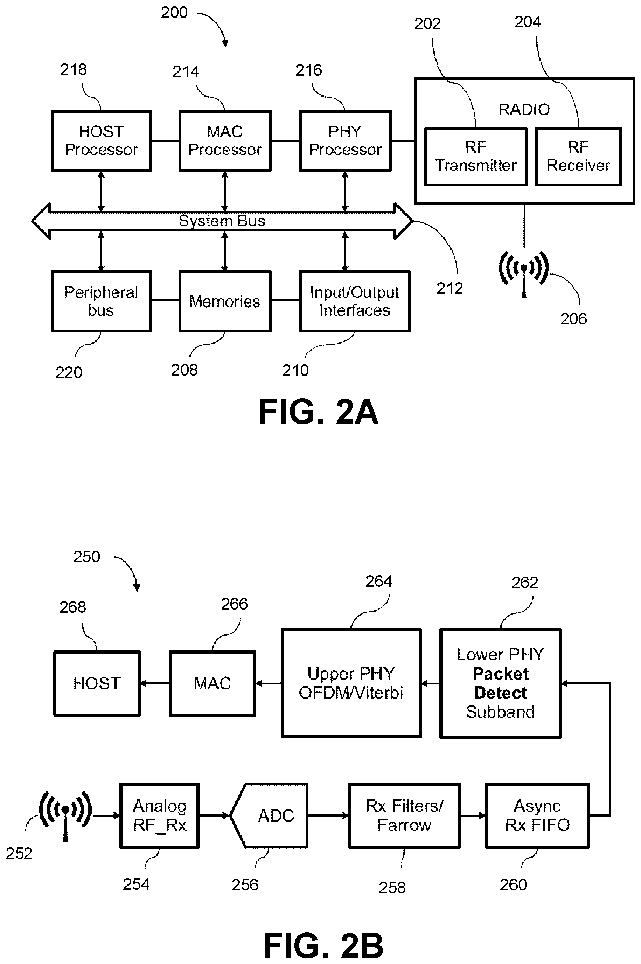

FIG. 2A is a high-level block diagram of an exemplary wireless communication device 200 that can be used to implement a STA or an AP, in some examples. The wireless communication device 200 can include a MAC layer and a PHY layer in accordance with one or more of the IEEE 802.11 standards.

The wireless communication device 200 includes a Radio Frequency (RF) transmitter module 202, an RF receiver module 204, an antenna unit 206, one or more memory banks 208, input and output interfaces 210, and communication bus 212. The RF transmitter module 202 and the RF receiver module 204 include a modem (modulator-demodulator device), which transmits data by modulating one or more carrier wave signals to encode digital information, as well as receives data by demodulating the signal to recreate the original digital information. As illustrated, the wireless communication device 200 further includes a MAC processor 214, a PHY processor 216 and a HOST processor 218. These processors can be any type of Integrated Circuit (IC) including a general processing unit, an Application Specific Integrated Circuit (ASIC) or Reduced Instruction Set Computer - Five (RISC-V) based ICs, amongst others.

The memory 208 can be used to store software and/or computer-readable instructions, including software or instructions that can be used to implement at least some functions of the MAC layer. For example, each processor included in the wireless communication device 200 (e.g., MAC processor 214, PHY processor 216, HOST processor 218, etc.) executes respective software to implement the functions of the respective communication/application layer.

The PHY processor 216 includes a transmitting signal processing unit and a receiving signal processing unit (not shown) and can be used to manage the interface with the Wireless Medium (WM). The PHY processor 216 operates on PPDUs by exchanging digital samples with the radio module which includes the RF transmitter 202, the RF receiver 204, analog-to-digital converters, and digital filters.

The MAC processor 214 executes MAC level instructions and manages the interface between the application software and the WM, through the PHY processor 216. The MAC processor 214 is responsible for coordinating access to the WM so that the Access Point (AP) and STAs in range can communicate effectively. The MAC processor 214 adds header and tail bytes to units of data provided by the higher levels and sends them to the PHY layer for transmission. The reverse happens when receiving data from the PHY layer. If a frame is received in error, the MAC processor 214 manages the retransmission of the frame.

The HOST processor 218 interfaces with the MAC layer and is responsible for running higher level functionalities of the wireless communication device.

The PHY processor 216, the MAC processor 214, the HOST processor 218, the peripheral bus 220, the memories 208, and the input/output interfaces 210 communicate with each other via the peripheral bus 212. The peripheral bus 220 connects to a number of peripherals that support core functions of the wireless communication device 200, including timers, interrupts, radio/filters/system registers, counters, UART, GPIO interfaces, among others. The memory 208 may further store an operating system and applications. In some examples, the memory may store recorded information about captured frames and packets. The input/output interface unit 210 allows for exchange of information with a user of the wireless communication device. The antenna unit 206 can include a single antenna and/or can include or multiple antennas. For example, multiple antennas can be used to implement Multiple Input Multiple Output (MIMO) techniques, among others.

FIG. 2B illustrates a schematic block diagram of a receiver data flow architecture 250 that can be used to receive Wi-Fi packets over the network. In one illustrative example, the receiver data flow architecture 250 illustrated in FIG. 2B can correspond to or otherwise be associated with the wireless communication device 200 illustrated in FIG. 2A. Radio signals are received over the WM and translated into electrical signals by the receiving antenna 252 (e.g., which can be the same as or similar to antenna 206). The received signal is conditioned using a series of analog filters 254 (e.g., depicted as analog RF receive (Rx) filters) before being converted into a digital signal equivalent using an Analog-to-Digital Converter (ADC) 256. The sampled signal output of ADC 256 is conditioned again using a filter bank 258, which can include one or more digital RF filters and/or a farrow, before the samples are collected in an asynchronous receiving First-In-First-Out (FIFO) data structure 260.

Samples in FIFO structure 260 can be accessed by a plurality of modules. For example, samples can be accessed by a packet detect module and a sub-band module, both of which may be included in the lower-level PHY portion 262 depicted in FIG. 2B. In some embodiments, the lower-level PHY portion 262 is itself included in the PHY processor 216 illustrated in FIG. 2A.

The packet detect module included in the lower-level PHY portion 262 can include hardware and/or implement algorithms that can be used to analyze the initial sections of the PPDU in the time domain. Based on the analysis, the packet detect module can be used to recognize a received frame and synchronize frequency and timing of the wireless communication device with the packet being received. The sub-band module included in the lower-level PHY portion 262 can include hardware and/or implement algorithms that can be used to detect which subchannel in the allocated frequency band is being used for the packet being received.

Once a packet is detected and the relevant subchannel is established, samples can be forwarded to an upper-level PHY portion 264. The upper-level PHY portion 264 can be included in the PHY processor 216 illustrated in FIG. 2A. In some aspects, upper-level PHY portion 264 can be used to process and decode Orthogonal Division Multiplexing (OFDM) symbols (e.g., with the support of a coprocessor module) to reconstruct the full PPDU. The reconstructed PPDU is output by the upper-level PHY portion 264 and subsequently processed by the MAC layer processor 266. The MAC layer processor 266 can be used to extract the data payload from the PPDU and provide the relevant information to the HOST layer 268 for consumption.

In some examples, the MAC layer processor 266 illustrated in FIG. 2B can be the same as or similar to the MAC processor 214 illustrated in FIG. 2A. In some cases, the HOST layer 268 illustrated in FIG. 2B can include or otherwise can be the same as or similar to the HOST processor 218 illustrated in FIG. 2A.

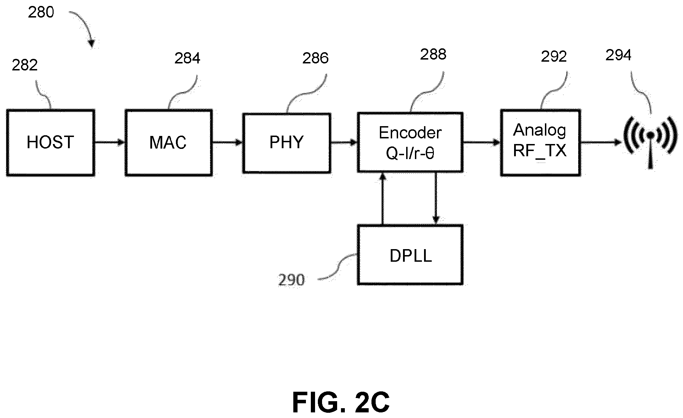

FIG. 2C is a schematic block diagram of a transmitter data flow architecture 280 that can be used to transmit RF signals over a wireless medium, in accordance with some examples. More particularly, FIG. 2C illustrates a simplified schematic block diagram of a transmitter data flow architecture 280 used for transmitting radio signals over a WM. Data can be generated from a HOST or APP module 282 and packaged in a MAC level Protocol Data Unit (MPDU) to be routed over the wireless network by the MAC management module 284. The PHY module 286 interfaces with the WM and compiles a PPDU by adding a PHY preamble and the tail to the MPDU. Usually a Modulation Coding Scheme (MCS) for transmission of the packet over the medium is established using a rate control algorithm by the MAC module 284 or the PHY module 286. The modulation scheme selected can define the modulation technique to be used to transmit the data on the WM and the coding rate. Based on the modulation scheme selected, for example Quadrature Amplitude Modulation (QAM) 64, the PPDU is modulated to be transmitted on the WM. The encoder module 288 generates signals corresponding to points of QAM constellation symbols (groups of bits of the PPDU) which can be encoded using polar $(r\text{-}\theta)$ or cartesian (Q-I) coordinates. The modulation is done by linking the encoder module 288 to a Digital Phase Lock Loop (DPLL) 290. The modulated signals may be filtered by analog filters 292 and transmitted using a transmitting antenna 294.

Many modern radio systems use Orthogonal Frequency Division Multiplexing (OFDM) modulation schemes with relatively large values of Peak-to-Average Power Ratio (PAPR). For example, larger (e.g., higher) PAPR values correspond to a greater difference between the peak RF output power and the average RF output power of the radio system. As noted above, radio systems often include one or more power amplifiers (PAs) that achieve their maximum power efficiency when the PA operates at its maximum output power, with the power efficiency of the PA reducing significantly as the output power is reduced from maximum. Higher PAPR values correspond to larger disparities between peak and average power levels, and it may be generally undesirable to configure the radio system to permit the peak RF output power level to exceed the maximum output power of the PA (e.g., to avoid distortion, etc.). As such, the peak power level is typically constrained to remain within the PA's maximum output capability, and the average power level is backed off to be below the PA's maximum output. Accordingly, high PAPR signals may correspond to the PA operating significantly below its peak output level, where the power efficiency is poor.

There is a need for systems and techniques that can be used to improve the power efficiency of a PA when operating at relatively high or relatively significant power back-off. For instance, most Wi-Fi systems (e.g., which are an example of a radio system using one or more PAs) operate with a PAPR between 8 decibels (dB) and 12dB. The average power level for Wi-Fi systems with a PAPR between 8-12 dB is approximately 10% of the peak power level, and the Wi-Fi system(s) power amplifiers therefore operate in a sub-optimal power efficiency regime for the majority of the time. One proposed technique to maximize the efficiency of a PA at 6dB back-off is based on combining the outputs of two separate PAs such that one of the PAs is operational across the desired output power range while the other PA is normally off, with the other PA available to act as a boost amplifier at high power output levels. This combination can allow both of the power amplifiers to spend a greater amount of time operating closer to their maximum efficiency across more of the power range. There remains a need for systems and techniques that can be used to apply the proposed technique to modern integrated PAs and/or DPAs.

For example, combining the outputs of two separate PAs with one PA operational across a configured power range and one PA available as a boost amplifier at higher power outputs has been challenging to implement for modern integrated PAs based at least in part on the large size of the combiner component that has previously been required, as well as the difficulty of designing a combiner can match consistently to the output impedance of each of the two PAs. For example, the output impedance of each PA will often vary considerably with the total output power.

In some embodiments, the systems and techniques described herein can be used to implement improved efficiency PAs based on combining outputs from two or more separate PAs, as noted above. In one illustrative example, Switched capacitor Power amplifiers (ScPas) are used to address challenges and problems that may otherwise be associated with the use of a Digital-to-Analog Converter (DAC), as ScPas are fully digital power amplifiers. Aspects of the disclosure include implementations where the ScPas are provided in combination with integrated Complementary Metal-Oxide-Semiconductor (CMOS) systems.

The systems and techniques described herein can be used to provide a digitally controlled ScPa system for power amplification with improved power efficiency. For example, the digitally controlled ScPa system can combine the outputs of two separate ScPas, based at least in part on the output impedance of an ScPa being observed to be constant across all gain settings. Advantageously, embodiments of the present disclosure can be implemented by configuring and/or reconfiguring components already present within an ScPa to obtain the combiner for combining the outputs of the two separate PAs. As such, the improved efficiency digitally controlled ScPa system described herein may be implemented without a requirement to add additional large and/or complicated physical circuitry, etc. In some embodiments, aspects of the disclosure include the ability, when operating in a Cartesian system, to configure the amplifier controls to combine In-phase (I) and Quadrature-phase (Q) signals without experiencing the degradation in efficiency that is normally associated with an integrated mixer. Further still, the systems and techniques can be used to provide a modification to the combiner arrangement that can maximize power efficiency at multiple back-off levels, including maximizing efficiency at a 12dB back-off as well as maximizing efficiency at a 6dB back-off.

In some embodiments, a digitally-controlled switched-capacitor power amplifier comprises two arrays of CMOS inverters, with each inverter driving its own unit capacitor, and with each complete array of capacitors connected to the primary inputs of an inductive balun/transformer. For example, a balun may refer to a type of transformer or electrical device configured to provide an interface between balanced and unbalanced lines (e.g., balanced-to-unbalanced, or "balun").

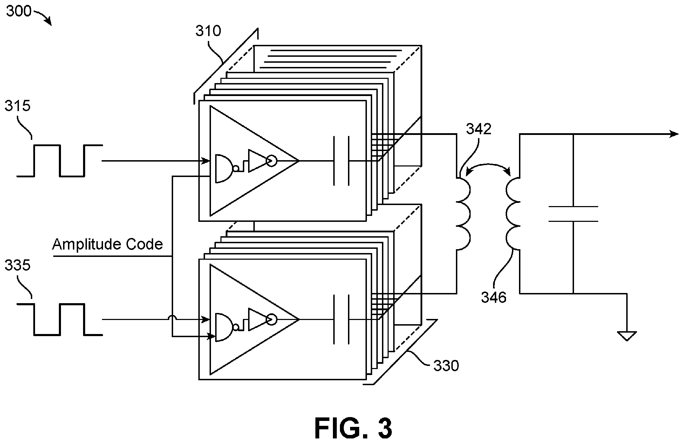

FIG. 3 illustrates an example of a digitally-controlled switched-capacitor power amplifier (ScPa) architecture 300 configured with two arrays of CMOS inverters, where each array includes a plurality of capacitors which are either driven or not driven by a corresponding inverter within the array. For example, the ScPa architecture 300 includes a first array 310 of CMOS inverters (also referred to as a first section of the ScPa), and a second array 330 of CMOS inverters (also referred to as a second section of the ScPa). One array of inverters is driven by a square wave, and the other array of inverters is driven by an anti-phase square wave, where both the square wave and the anti-square wave are at the desired RF output frequency for the ScPa architecture 300. For example, the first array of inverters 310 can be driven by a square wave 315, and the second array of inverters 330 can be driven by an anti-square wave 335. The square wave 315 and the anti-square wave 335 can each be associated with a desired (e.g., configured, etc.) RF output frequency for the ScPa architecture 300.

The first array 310 and the second array 330 each includes a respective plurality of inverters (e.g., CMOS inverters). Within each array, some of the inverters are driven and some are held static. For example, a first subset of the plurality of CMOS inverters of the first array 310 may be driven while a second subset of the plurality of CMOS inverters of the first array 310 are held static. Likewise, a first subset of the plurality of CMOS inverters of the second array 330 may be driven while a second subset of the plurality of CMOS inverters of the second array 330 are held static. The proportion of inverters that are either driven or held static within a given array of the ScPa architecture 300 (e.g., within the first array 310 or the second array 330) can be configured according to a digital amplitude control signal, for example such as the amplitude code provided as input to the first array 310 and the second array 330. Based on varying the number of inverters that are active or static within a given array, the array forms a capacitive divider where the output voltage amplitude is proportional to the number of active inverters. The complete differential inverter-capacitor-inductor circuit forms a series resonant circuit that is tuned to the desired operating frequency for the ScPa architecture 300, leading to high currents at the desired operating frequency, and attenuation of the RF harmonics that are created by the square-wave drive signal(s) 315, 335. As noted above, the first array 310 and the second array 330 can be connected to the primary inputs (e.g., associated with a primary coil) of a balun, which is shown in the example of FIG. 3 as comprising a balun primary coil 342 and a balun secondary coil 346. The high current in the balun primary coil 342 is coupled to the balun secondary coil 346, where the current is transformed in impedance and converted to a single ended signal that can be driven directly into a transmitting antenna.

The inverters within each array of the ScPa are either driven or held static, as noted above. A static inverter has exactly the same output impedance as a clocked inverter, and as such, the impedance and frequency of the resonant circuit (e.g., the resonant circuit formed by the complete differential inverter-capacitor-inductor circuit of the ScPa architecture 300, etc.) is unaffected by the digital code or amplitude control signal that is used to configure the proportion of inverters that are driven within the arrays.

A static unit (e.g., the subset of inverters within an array that are held static) attenuates the signal by creating a capacitive load on the active units (e.g., the subset of inverters within an array that are driven). Accordingly, the power that is lost in any inactive unit (e.g., each inverter that is held static) can be determined according to $P = fCV$, where $P$ represents the power dissipated, $f$ is the RF output frequency or switching frequency of the inverter, $C$ is the capacitance, and $V$ is the voltage. Inactive inverter units still draw power via their capacitive loading, and accordingly, the efficiency of the ScPa can be seen to degrade proportional to the number of inactive units within each array. For example, a larger proportion of inactive inverter units within the ScPa corresponds to a larger amount of dissipated power by the inactive inverter units and results in a lower overall ScPa power efficiency. Based on each inactive inverter unit dissipating power according to $P = fCV$, it can be seen that the ScPa efficiency is maximized when all inverter units are active (e.g., thereby eliminating the power dissipation/loss associated with holding static the inactive inverters).

Existing ScPa designs drive the primary coil of the balun (e.g., primary coil 342) with a differential signal of varying amplitude from the two arrays of inverters and capacitors (e.g., first array 310 and second array 330). Aspects and embodiments of the present disclosure can be used to implement and/or provide a balun/transformer with an improved common-mode rejection that allows an ScPa to be driven without the use of the conventional differential drive approach. For example, with the improved common-mode rejection balun/transformer, differential driving of the primary coil 342 of the balun is not necessary, and the same or similar performance may be achieved by applying two independent drive signals to the two ends of the balun primary coil 342.

In some aspects, the two inverter and capacitor arrays within the ScPa can be treated as independent amplifiers, to enable the improved efficiency scheme where a first PA output is operational across a desired power range, and where a second PA output is operational as a boost amplifier at higher power output levels. For example, the first inverter and capacitor array 310 can be used as an independent amplifier associated with applying a first independent drive signal to the first end of the balun primary coil 342; the second inverter and capacitor array 330 can be used as a second independent amplifier associated with applying a second independent drive signal to the second end of the balun primary coil 342. In some embodiments, the balun primary coil 342 can be used to provide the combination of the two inverter and capacitor arrays 310 and 330 that is needed for the efficiency enhancement (e.g., the balun primary coil 342 can be used as a combiner component for the improved efficiency ScPa configuration based on combining the outputs of the two independent PAs operational at different power ranges). The combining functionality provided by the balun primary coil 342 is constant irrespective of amplitude code, and the different amplitude outputs from the two inverter and capacitor arrays 310 and 330 add together with good linearity.

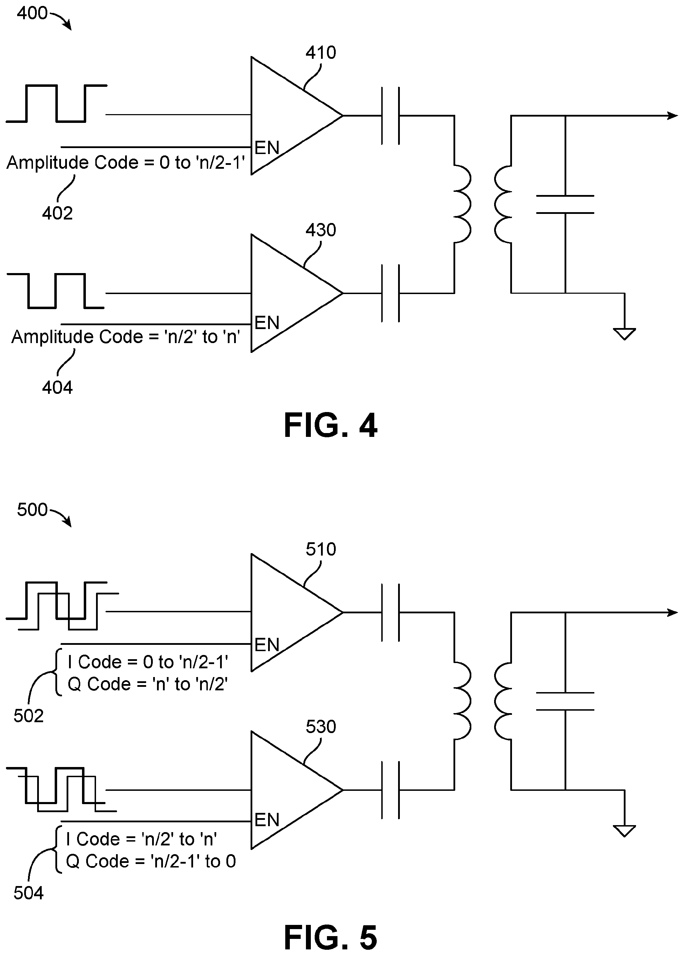

For example, FIG. 4 is a diagram illustrating an example of a combined driving scheme 400 of an ScPa architecture implemented using a non-Cartesian system. The ScPa architecture shown in FIG. 4 may be the same as or similar to the example ScPa architecture 300 of FIG. 3. In the example non-Cartesian scheme shown in FIG. 4, the amplitude code is split into two halves or portions, with a bottom half of the amplitude code 402 represented as the range 0 to $n/2 - 1$, and with a top half of the amplitude code 404 represented as the range $n/2$ to n.

In some embodiments, the scheme shown in FIG. 4 is implemented by applying the bottom half of the amplitude code 402 to the first inverter and capacitor array 410 with the second inverter and capacitor array 430 held static. The first inverter and capacitor array 410 of FIG. 4 can be the same as or similar to the first array 310 of FIG. 3. Similarly, the second inverter and capacitor array 430 of FIG. 4 can be the same as or similar to the second array 330 of FIG. 3. The bottom half of the amplitude code 402, from 0 to $n/2 - 1$, is applied to only the first array 410 while the second array 430 continues to be held static, until the first array 410 becomes fully driven and is therefore operating at maximum efficiency. For example, the first array 410 becomes fully driven and operates at its maximum configured output power level, which corresponds to the first array 410 operating at its maximum power efficiency. Once the first array 410 is fully driven and operating at maximum efficiency, the top half of the amplitude code 404 can then begin being applied to the second inverter and capacitor array 430, while leaving the first inverter and capacitor array 410 fully driven. In some examples, the driving scheme for the non-Cartesian system 400 shown in FIG. 4 may also be referred to herein as a "combined scheme," for example based on using the balun primary coil to provide the combination of the outputs of the first and second arrays 410 and 430, respectively.

As noted above, the combined driving scheme 400 of FIG. 4 corresponds to an example of an ScPa implemented in a non-Cartesian system. FIG. 5 illustrates an example of an ScPa combined driving scheme 500 implemented in a Cartesian system for an ScPa architecture including a first inverter and capacitor array 510 and a second inverter and capacitor array 530. For example, a non-Cartesian system (e.g., such as a polar system, etc.) may represent an RF input signal using magnitude and phase information, while a Cartesian system may use rectangular coordinates to represent signals, for instance using an In-phase (I) signal component and a Quadrature-phase (Q) signal component. In some examples, the Cartesian system can use separate amplification paths for the I and Q signal components, followed by recombination of the I and Q signals from their respective separate amplifications paths.

In the example Cartesian system combined driving scheme 500, the first inverter and capacitor array 510 of FIG. 5 can be the same as or similar to one or more of the first array 310 of FIG. 3 and/or the first inverter and capacitor array 410 of FIG. 4. The second inverter and capacitor array 530 of FIG. 5 can be the same as or similar to one or more of the second array 330 of FIG. 3 and/or the first inverter and capacitor array 430 of FIG. 4. The Cartesian system uses two clocks that are 90 degrees out of phase, for example also referred to as I and Q clocks. The I and Q components are coupled through different capacitors of the arrays according to a coding circuit that maps amplitudes of the I and Q components to the various different capacitor arrays, and in particular, with the amplitudes of the I and Q components coded into amplitude codes configured to control which capacitors in each array (e.g., first and second arrays 510 and 530) are driven, rather than being held static.

In some embodiments, the systems and techniques described herein can achieve similar power amplifier efficiency enhancements (e.g., improvements, increases, etc.) for a Cartesian system as in the examples above provided with respect to the non-Cartesian system. For example, same or similar power efficiency enhancements can be provided based on dividing the I amplitude code and the Q amplitude code into respective top halves and bottom halves, and distributing the I and Q amplitude code top and bottom halves between the first and second inverter and capacitor arrays 510 and 530, respectively.

In one illustrative example, the first inverter and capacitor array 510 can be used for an input 502 comprising the bottom half of the I amplitude code (e.g., the bottom half of the I amplitude code from 0 to $n/2 - 1$) and the top half of the Q amplitude code (e.g., the top half of the Q amplitude code from n to $n/2$). The second inverter and capacitor array 530 can be used for an input 504 comprising the top half of the I amplitude code (e.g., the top half of the I amplitude code from $n/2$ to n) and the bottom half of the Q amplitude code (e.g., the bottom half of the Q amplitude code from $n/2 - 1$ to 0). In this example, each of the two arrays 510 and 530 is used for the bottom half of one code (e.g., either the bottom half of the I code, or the bottom half of the Q code) and the top half of the other code (e.g., either the top half of the Q code, or the top half of the I code). Each code is split across the two arrays 510 and 530, and neither array processes only bottom halves or only top halves.

In some embodiments, allocation of the digital I-Q amplitude codes to different branches of inverter and capacitor arrays of the amplifier (e.g., allocation of the respective I and Q amplitude codes between the first inverter and capacitor array 510 and the second inverter and capacitor array 530) can be configured to allow the switched capacitor power amplifier to run each of the branches (e.g., with the first branch comprising/corresponding to the first array 510, and the second branch comprising/corresponding to the second array 530, etc.) at the maximum power, and therefore maximum power efficiency, as much time as possible.

In some embodiments, further enhancements may be implemented based on further splitting or division of the first and second branches of inverter and capacitor arrays 510 and 530. For example, the division in the example of FIG. 5 corresponds to a division between the first branch of inverter and capacitor arrays 510, and the second branch of inverter and capacitor arrays 530. In some embodiments, one or more divisions can be applied to split the inverter and capacitor arrays within the same branch (e.g., 510 or 530) into two halves, into four quarters, ..., etc. These further divisions can allow the ScPa system to be operated or driven using greater than two separate branches of inverter and capacitor arrays that may be combined in various different combinations.

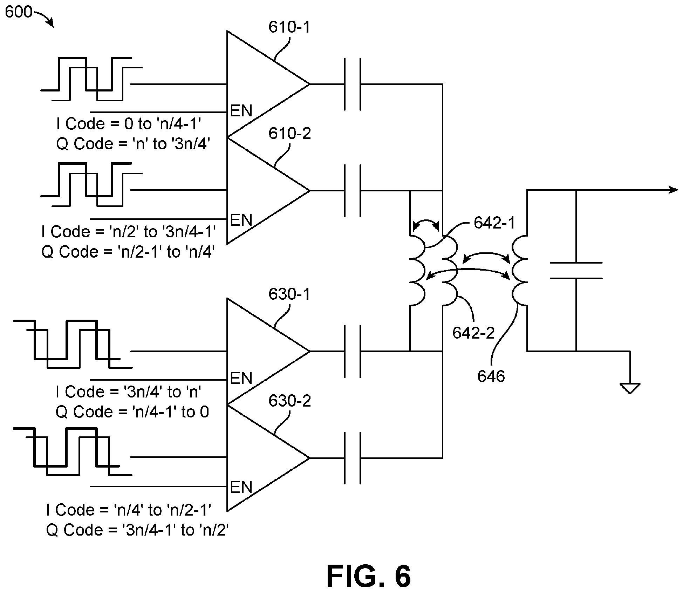

In one illustrative example, each of the two branches shown in FIG. 5 (e.g., 510 and 530) can be split or divided into two halves, to obtain a total of four separate branches of inverter and capacitor arrays that are available for combination. For instance, FIG. 6 is a diagram illustrating an example of a combined driving scheme 600 for an ScPa architecture implemented using a Cartesian system and four branches of inverter and capacitor arrays. The I and Q amplitude codes can be split into quarters and distributed among a first branch of inverter and capacitor arrays 610-1, a second branch of inverter and capacitor arrays 610-2, a third branch of inverter and capacitor arrays 630-1, and a fourth branch of inverter and capacitor arrays 630-2.

For example, the first branch of inverter and capacitor arrays 610-1 can be used for I codes from 0 to $n/4 - 1$ and Q codes from n to $3n/4$. The second branch of inverter and capacitor arrays 610-2 can be used for I codes from

$n/2$ to $3n/4 - 1$ and Q codes from $n/2 - 1$ to $n/4$. The third branch of inverter and capacitor arrays 630-1 can be used for I codes from $3n/4$ to n and Q codes from $n/4 - 1$ to 0. The fourth branch of inverter and capacitor arrays 630-2 can be used for I codes from $n/4$ to $n/2 - 1$ and Q codes from $3n/4 - 1$ to $n/2$.

The balun primary can be implemented as a series resonant balun primary formed from two tightly coupled inductors 642-1 and 642-2. The balun secondary 646 can be the same or similar to the balun secondary 346 of FIG. 3, etc. The inductor 642-1 can be connected to the output of the second branch of inverter and capacitor arrays 610-2 and the third branch of inverter and capacitor arrays 630-1. The inductor 642-2 can be connected to the output of the first branch of inverter and capacitor arrays 610-1 and the fourth branch of inverter and capacitor arrays 630-2. Although the topology of the balun increases in complexity, the overall dimensions of the balun shown in FIG. 6 are not significantly increased.

Embodiments of the invention make the Cartesian application of the system more feasible. The concept of the invention can be extended to multiple branches using multiple coupled transformer (e.g., balun) primaries. To the extent that the transformer is not perfectly balanced between its multiple inputs, the combination will only exhibit a small linear gain difference between each combined amplifier, which is much more easily remediated than the complicated pre-distortion techniques that are required for other integrated amplifier architectures.

As noted above, the systems and techniques described herein can be used to improve the efficiency of switched capacitor power amplifiers and/or various other digital power amplifiers. Digital PAs not only improve the energy efficiency of the RF transceiver, but also reduce the chip area required. For an ScPa digital PA implementation using a Cartesian system, the I and Q components of a signal are coupled through different capacitor arrays of the ScPa by using a coding circuit to map the respective amplitudes of the I and Q components to different combinations of capacitor arrays. The amplitudes of the I and Q components are coded into amplitude codes to control or configure which capacitors in each capacitor array are turned on (e.g., rather than held static). Aspects of the present disclosure can be used to address limitations of existing techniques for digital power amplification, including the fact that the performance of a conventional digital PA decreases (e.g., degrades, becomes inferior, etc.) when the absolute value of an I sample and the absolute value of the corresponding Q sample are too large.

Specifically, the digital PA performance can be seen to degrade below an acceptable level when the sum of absolute values (e.g., magnitudes) of the I and Q components exceeds a certain threshold value. This threshold value for degradation of digital PA performance can be a value that is based on, and/or corresponds to, the number of bits used to represent the I and Q samples. For example, in a 16-bit DAC used in an RF transceiver, 1 bit represents the sign and 15 bits represent the amplitude, and each of the I and Q samples is therefore represented by a 15-bit amplitude code. The threshold value for preventing the performance degradation in a digital PA can be determined as 2 to the power of the bit-length of the I and Q samples. For the example of the 16-bit DAC where each of the I and Q samples are 15 bit amplitude codes, the threshold value of digital PA performance degradation is $2^{15} = 32768$.

In other words, the digital PA performance degrades when $|I| + |Q| > 32768$, where I represents the sample on the in-phase path and Q represents the sample on the quadrature-phase path. The threshold value for digital PA performance degradation may be determined according to the bit-width of the DAC or the number of bits used to represent the amplitude of the I/Q samples, as noted in the examples above. In some cases, the digital PA performance degradation may be caused by undesirable mirror behavior exhibited by the digital PA when the sum of the absolute values of I and Q exceeds the threshold value. For example, there is a mirror image distortion resulting from an ScPa on the I/Q samples with a sum of the absolute I and Q values exceeding the threshold value. In some examples, these IQ samples with a magnitude sum that exceeds the threshold value can be indicated by a clipping rhombus overlaid on the IQ constellation diagram. The IQ samples inside of (e.g., enclosed by) the clipping rhombus are IQ samples with a magnitude sum less than the digital PA performance degradation threshold. The IQ samples outside of the clipping rhombus are I/Q samples with a magnitude sum greater than the digital PA performance degradation threshold. The IQ samples that are on the clipping rhombus are the IQ samples with a magnitude sum equal to the digital PA performance degradation threshold.

In one illustrative example, aspects and embodiments of the invention can be used to correct the mirror image distortion by an analog circuit block of a digital PA. In a conventional quadrature ScPa system, two sub-ScPas are provided, with one sub-ScPa dedicated for I signals and with the other sub-ScPa dedicated for Q signals. The number of capacitors switched between $V_{DD}$ (e.g., the positive supply voltage/high voltage rail) and $V_{ground}$ (e.g., the low voltage rail/reference ground) for each sub-ScPa is between 0 and ½ of the total number of capacitors, N. The total number of capacitors in the dedicated capacitor arrays for I and Q signals demonstrates efficiency degradation due to the split where each sub-ScPa uses at most only a portion of the total array, and corresponds to the dedicated IQ array architecture having 3 to 6 dB lower output power and a degraded drain efficiency compared to an equivalent polar ScPa. A quadrature IQ shared cell ScPa employs combined unit vectors with a flexible vector allocation increasing the output power.

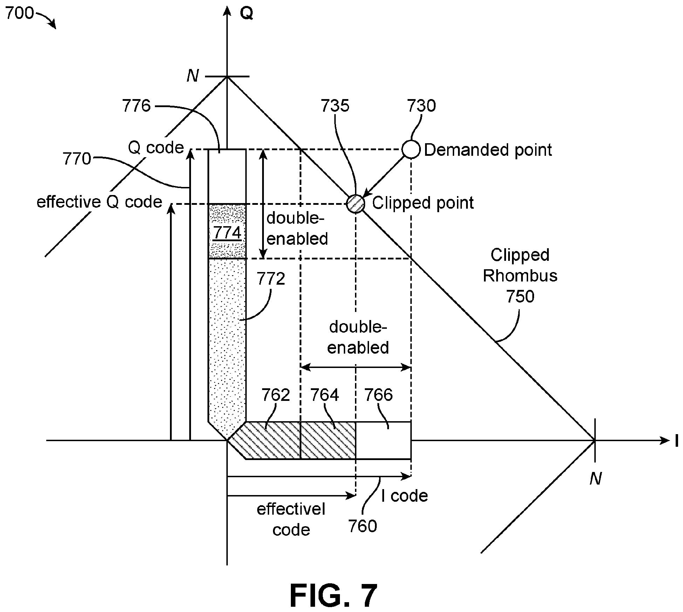

FIG. 7 is an IQ constellation diagram 700 illustrating a clipping rhombus 750 corresponding to a performance degradation threshold for a digital power amplifier. For example, the clipping rhombus 750 can correspond to the digital PA performance degradation threshold discussed above, given by $2^{num\_bits}$ with the value of num_bits equal to the bit-width of the DAC or the number of bits used to represent the amplitude of the I/Q samples. In some aspects, the clipping rhombus 750 includes the set of IQ samples with |I| + |Q| = configured threshold value (e.g., the set of IQ samples with |I| + |Q| = $2^{num\_bits}$). The region of the IQ constellation diagram 700 that is outside of the clipping rhombus 750 can be referred to as the clipping region, and includes the set of IQ samples with |I| + |Q| > configured threshold value (e.g., the set of IQ samples with $|I| + |Q| > 2^{num\_bits}$).

In the example of FIG. 7, clipping is shown from a demanded point 730 corresponding to an IQ sample in the clipping region (e.g., outside of the clipping rhombus 750), to a clipped point 735 that lies on the clipping rhombus 750. The clipping from the demanded point 730 to the clipped point 735 can be used to reduce or prevent performance degradation associated with exceeding the configured threshold of the clipping rhombus 750, and can be used to prevent or mitigate the undesirable mirror behavior noted previously above, etc. In one illustrative example, the clipping from the demanded point 730 to the clipped point 735 can be performed according to an analog clipping scheme configured for a DPA and/or ScPa system, according to various embodiments of the invention. For example, in some embodiments, the clipping scheme can be performed to clip from various demanded points comprising I/Q samples within the clipping region (e.g., outside the clipping rhombus 750), to a respective clipped point that lies on or within the clipping rhombus 750. In some aspects, the respective clipped point comprises an orthogonal projection of any arbitrary demanded point within the clipping region onto the clipping profile given by the clipping rhombus 750.

In some embodiments, the analog clipping scheme may be implemented based on setting two control bits configured to control each output unit of the capacitor array in an IQ shared cell ScPa system, such that the control bits provide a prioritization and/or handling logic for any "double-enabled" units that are commanded by both I and Q signals simultaneously.

In particular, the clipping rhombus 750 can correspond to the boundary of the amplifier's linear operating region, where the total number of active units demanded for an I and Q code combination (e.g., IQ sample) does not exceed the total available capacity of the number of capacitor units, N, within the capacitor array of the IQ shared cell ScPa. For example, the number of capacitor units demanded by the I code is |I| and the number of capacitor units demanded by the Q code is |Q|, corresponding to the degradation condition noted above where performance degradation of the digital PA is observed when |I| + |Q| > threshold. As such, the clipping rhombus 750 can be seen to represent the threshold given by the total number of capacitor units, N, within the shared cell ScPa array. IQ samples within the clipping rhombus 750 do not exceed the number of output units in the capacitor array, and satisfy $|I| + |Q| \leq N$. IQ samples outside of the clipping rhombus 750 are the I and Q amplitude combinations that demand a number of units that exceeds the total number of capacitor units in the capacitor array, i.e., |I| + |Q| > N.

In an IQ shared cell ScPa, each output cell of the plurality of output cells (N) of the capacitor array can be driven by either the I or Q clock. The output cells of the capacitor array are also variously referred to herein as the "output units," "capacitor units," and/or "capacitor cells." As noted above, there is a limitation on the number of output cells driven by the I and Q clock, where the limitation depends on the number of output units in the capacitor array, N. The limitation occurs when the sum of the number of output cells driven or demanded by the I clock (e.g., |I|) with the number of output cells driven or demanded by the Q clock (e.g., |Q|) is greater than the number of output units N within the shared capacitor array (e.g., |I| + |Q| > N).

In some embodiments of the IQ shared cell ScPa, each respective output unit of the plurality of output units (e.g., N) within the shared capacitor array can be implemented with two control bits to define the operating state of the respective output unit. For example, a first control bit can be used to enable operation from and/or prioritization of the I clock, and a second control bit can be used to enable operation from and/or prioritization of the Q clock. The first control bit may also be referred to herein as the "I control bit" or "I-clock control bit". The second control bit may also be referred to herein as the "Q control bit" or "Q-clock control bit". Each control bit may take a low value (e.g., '0') or a high value (e.g., '1').

For example, when both control bits for a given output unit in the capacitor array are set to low (e.g., I control bit = 0, Q control bit = 0), the output unit operating state is set to 'off.' When one control bit is set to high and the other control bit is low, the output unit operating state is driven by whichever one of the I or Q clock has the control bit with the high value. For example, setting I control bit = 1, Q control bit = 0 corresponds to the output unit operating state driven by the I clock. Similarly, setting I control bit = 0, Q control bit = 1 corresponds to the output unit operating state driven by the Q clock.

When the ScPa enters a clipping region (e.g., the clipping region beyond the clipping rhombus 750 of FIG. 7), the number of output cells demanded by I and Q is greater than the number of output cells in the capacitor array, |I| + |Q| > N. Within the clipping region, a portion of the output cells in the capacitor array become "double-enabled" and have both the I control bit and the Q control bit set high. For example, an output cell of the capacitor array is double-enabled when I control bit = 1, Q control bit = 1. In an IQ shared cell ScPa, the shared cell design of the capacitor array allows for sharing of the same capacitor array between the I and Q clock, but individual cells/output units within the capacitor array are driven by only one of either the I clock or the Q clock (e.g., individual cells/output units are not themselves shared, and cannot be simultaneously driven by I and Q). As such, the double-enabled control bit condition with both the I control bit and the Q control bit can cause a conflict at the double-enabled output cells of the capacitor array. The double-enabled output cells of the shared capacitor array are the subset cells that have both control bits set high, i.e., the output cells that receive I and Q clock due to the ScPa entering the clipping region. In some ScPa designs, double-enabled output cells are simply deactivated, held static, or have their operating state set to 'off,' due to the incompatibility of the double-enabled control bit condition with the requirement that a given output cell of the capacitor array be driven by only one of either the I clock or the Q clock.

In some aspects, the number of double-enabled cells when the ScPa enters a clipping region is equal to $|I| + |Q| - N$, or the amount by which the number of demanded units by I and Q exceeds the number of units N within the shared capacitor array. In the example shown in FIG. 7, the 'I code' 760 and the 'Q code' 770 correspond to the demanded point 730 that is located within the clipping region beyond the clipping rhombus 750. The total number of output units in the capacitor array is N, with the clipping rhombus 750 intersecting the I-axis at (I=N, Q=0) and with the clipping rhombus 750 intersecting the Q-axis at (I=0, Q=N).

The I code 760 is shown divided into a first I code portion 762, a second I code portion 764, and a third I code portion 766. Similarly, the Q code 770 is shown divided into a first Q code portion 772, a second Q code portion 774, and a third Q code portion 776.

The second and third I code portions, 764 and 766, are double-enabled with the second and third Q code portions, 774 and 776. The number of double-enabled cells is the same within the I code 760 and the Q code 770, that is, the number of output cells for the I code portions 764 and 766 = the number of output cells for the Q code portions 774 and 776. The number of double enabled output cells associated with the demanded point 730 is equal to $|I| + |Q| - N$.

The first I code portion 762 corresponds to the set of output cells that are driven by I without being double-enabled (e.g., the set of output cells with I control bit = 1, Q control bit = 0). The first Q code portion 772 corresponds to the set of output cells that are driven by Q without being double-enabled (e.g., the set of output cells with I control bit = 0, Q control bit = 1).

Embodiments of the present invention can be used to provide an analog clipping scheme that controls the behavior of the operating state of one or more double-enabled output cells that have both control bits set high (e.g., I control bit = 1, Q control bit = 1). The analog clipping scheme may be implemented locally at each respective output unit of the shared capacitor array to ensure that, if the respective output unit becomes double-enabled, the double-enabled output unit can determine a respective prioritization for selecting either the I or Q control bit. By providing local prioritization logic at each output unit of the capacitor array, double-enabled units will still contribute to the combined output signal of the IQ shared cell ScPa (e.g., rather than setting their operating state to 'off' in response to being double-enabled, as may occur in existing ScPa designs). The analog clipping scheme may be implemented as local analog logic, circuitry, etc., associated with each output unit of the capacitor array, allowing for demanded points (e.g., demanded point 730) outside of the clipping rhombus 750 to be automatically clipped to the perimeter of the clipping rhombus 750 without requiring or using a central clipping module to detect the clipping condition globally and reconfigure the ScPa in response.

In some embodiments, the analog clipping logic can be implemented locally for the respective output cells/units of the shared capacitor array to define the operating state behavior of the output cells when both control bits are set high. These output cells having both the control bits set high are also referred to as double-enabled output cells. In some embodiments, the analog clipping scheme applied by the IQ shared cell ScPa results in a first half of the output cells that are double-enabled applying a prioritization logic to operate from the I clock, and a second half of the output cells that are double-enabled applying a prioritization logic to operate from the Q clock. For example, the analog clipping scheme can be implemented locally by assigning or configuring each respective output cell of the plurality of output cells, N, of the shared capacitor array with a respective priority. Half of the output cells N can be configured to prioritize operation from the I clock when or if the cell becomes double-enabled, while the remaining half of the output cells N are configured to prioritize operation from the Q clock when or if the cell becomes double-enabled.

In the example of FIG. 7, the local prioritization logical of the analog clipping scheme results in the orthogonal projection of any demanded point 730 from outside the clipping rhombus 750 to a location on clipping rhombus 750. The orthogonal projection is based on the local prioritization logic prioritizing ½ of the double-enabled bits to operate from the I clock and ½ of the double-enabled bits to operate from the Q clock.

For instance, the clipped point 735 of FIG. 7 corresponds to the effective I code (e.g., clipped I code) corresponding to the first and second I code sections 762 and 764, with the third I code section 766 removed (e.g., clipped). The clipped point 735 likewise corresponds to the effective Q code (e.g., clipped Q code) corresponding to the first and second Q code sections 772 and 774, with the third Q code section 776 removed (e.g., clipped).

The I code section 764 represents the ½ of the double-enabled cells that prioritize operation from the I clock. The I code section 766 is clipped, and represents the ½ of the double-enabled cells that have the I control bit set high, but are locally configured to prioritize the Q control bit and disregard the I control bit.

Similarly, the Q code section 774 represents the ½ of the double-enabled cells that prioritize operating from the Q clock. The Q code section 776 is clipped, and represents the ½ of the double-enabled cells that have the Q control bit set high, but are locally configured to prioritize the I control bit and disregard the Q control bit.

In some embodiments, the analog clipping scheme can be implemented according to different truth tables configurations that can be applied and/or defined for alternating interleaved output cells within the capacitor array. Half of the doubled-enabled output cells use the I clock when both the I and Q clocks are enabled, while the other half of the double-enabled output cells use the Q clock when both the I and Q clocks are enabled. In some embodiments, the split priority between I clock and Q clock for double-enabled output cells can be implemented based on the ScPa utilizing different truth tables for even-indexed and odd-indexed output cells (e.g., based on ½ of the ScPa capacitor array output cells being even-indexed, and ½ of the ScPa capacitor array output c ells being odd-indexed):

Table 1. Example truth table configuration for an IQ shared cell ScPa, where the truth table is configured for even-indexed output cells of the capacitor array and odd-indexed output cells of the capacitor array. 'EN_I' corresponds to the I control bit and 'EN_Q' corresponds to the Q control bit, with a value of '0' corresponding to low and a value of '1' corresponding to high. 'State' represents the operating state of the output cell.

| Truth table for even-index output cells | | | | Truth table for odd-index output cells | | |
|---|---|---|---|---|---|---|
| **EN_I** | **EN_Q** | **State** | | **EN_I** | **EN_Q** | **State** |
| 0 | 0 | Off | | 0 | 0 | Off |
| 1 | 0 | I clock | | 1 | 0 | I clock |
| 0 | 1 | Q clock | | 0 | 1 | Q clock |
| 1 | 1 | ***I clock*** | | 1 | 1 | ***Q clock*** |

In the example of Table 1, the truth table for even-indexed output cells configures each even-indexed output cell of the capacitor array to prioritize operation driven by the I clock, such that the even-indexed output cells operate from the I clock if double-enabled. The truth table for odd-indexed output cells configured each odd-indexed output cell of the capacitor array to prioritize operation driven by the Q clock, such that the odd-indexed output cells operate from the Q clock if double-enabled.

As shown in FIG. 7, instead of driving the output cells N of the capacitor array with the original Q code 770 and I code 760 corresponding to the demanded point 730, the output cells are driven by effective Q and I codes that are clipped to the boundary of the clipping rhombus 750. The effective Q code (e.g., comprising the Q code portions 772 and 774) is realized by assigning a number of output cells enabled according to the original Q code to be double-enabled output cells, where both the two control bits (EN_I, EN_Q) of the double-enabled output cells are all equal to 1. Similarly, the effective I code (e.g., comprising the I code portions 762 and 764) is realized by assigning a number of output cells enabled by the original I code to be doubled-enabled output cells. Based on the truth tables of Table 1, above, the operating state for the even-indexed double-enabled output cells (1, 1) is the I clock while the operating state for the odd-indexed double-enabled output cells (1, 1) is the Q clock.

For example, the I code portion 764 can correspond to the even-indexed double-enabled output cells that are configured by the truth table to prioritize the I code. The I code portion 766 that is clipped can correspond to the odd-indexed double-enabled output cells that are configured by the truth table to prioritize the Q code. Similarly, the Q code portion 774 can correspond to these odd-indexed double-enabled output cells that are configured by the truth table to prioritize the Q code (e.g., the double-enabled output cells used for the effective Q code and portion 774 may be the same as the double-enabled output cells that are clipped as the portion 766 removed from the I code 760). The Q code portion 776 can correspond to the even-indexed double-enabled output cells that are configured by the truth table to prioritize the I code (e.g., the double-enabled output cells used for the effective I code and portion 764 may be the same as the double-enabled output cells that are clipped as the portion 776 removed from the Q code 770).

In another embodiment, even-indexed double-enabled output cells are Q clock enabled while odd-indexed double-enabled output cells are I clock enabled. By doing so, the number of I clock enabled output cells is reduced by half of the number of double-enabled output cells, and the number of Q clock enabled output cells is reduced by half of the number of double-enabled output cells, which achieves the desired clipping behavior from the demanded point to the clipped point.

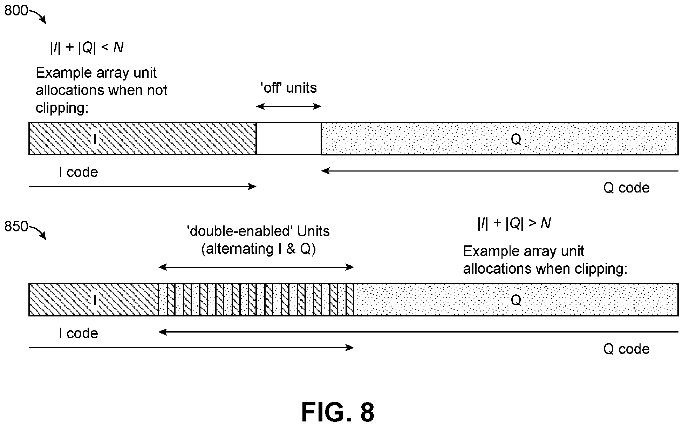

FIG. 8 is a diagram illustrating an example of capacitor array unit (e.g., an output cell) allocation 800 when clipping is not required for the IQ-shared-cell ScPa, and an example of capacitor array unit allocation 850 when clipping is required for the IQ-shared-cell ScPa according to an embodiment of the present invention. In the example allocation 800, clipping is not required when the total number of I and Q enabled output cells is less than the total number of output cells N (e.g., $\|I\| + \|Q\| < N$). In the example of the non-clipping allocation 800, a subset of output cells have an 'Off' operating state, where the number of output cells with the 'Off' operating = $N - \|I\| - \|Q\|$.

In the example of the clipping allocation 850, when the sum of the absolute value of I and the absolute value of Q is greater than the number of output cells N (e.g., $\|I\| + \|Q\| > N$), a number of output cells equal to the difference between $\|I\| + \|Q\|$ and N (e.g., $\|I\| + \|Q\| - N$) will become double-enabled output cells. The operating states of these double-enabled output cells are determined according to the local analog clipping logic described above, and for example implemented locally at each output cell of the capacitor array according to the example truth table of Table 1, etc. In some aspects, the double-enabled output cells have operating states set to alternating I and Q clocks enabled as half of the double-enabled output cells have an operating state of I clock enabled and another half will have an operating state of Q clock enabled.

In some examples, ScPa output units of the capacitor array are normally driven from a high voltage rail (e.g., IO voltage) to maximize power output, while a clock tree and control code tree are run from a low voltage rail (e.g., core voltage) to maximize the speed and to minimize the gate area and operating current. Accordingly, the clock signals driving into each output unit are voltage level shifted in order to control the PMOS switch device in the output unit. Traditional logic level voltage shifters are relatively large, slow, and current-hungry when used at faster clock speeds, such as those that may be used for and/or desirable for the ScPa output units. Systems and techniques that can be used to vary the voltage of the high voltage rail would be beneficial, as changing (e.g., varying) the voltage on the high voltage rail can provide an easy and efficient way to vary the peak power output of the ScPa. However, in many examples, traditional (e.g., conventional, existing, etc.) logic level shifters experience rapid performance degradation as the high-voltage rail drops in voltage.

In some examples, an ScPa output unit is formed from a stack of four core devices, namely, two switch devices and two cascode devices, as such a configuration can allow small low resistance switch devices while still limiting device Vds and Vgs to safe levels. The Vds and Vgs of core devices must be kept to less than the specified core voltage for the process.

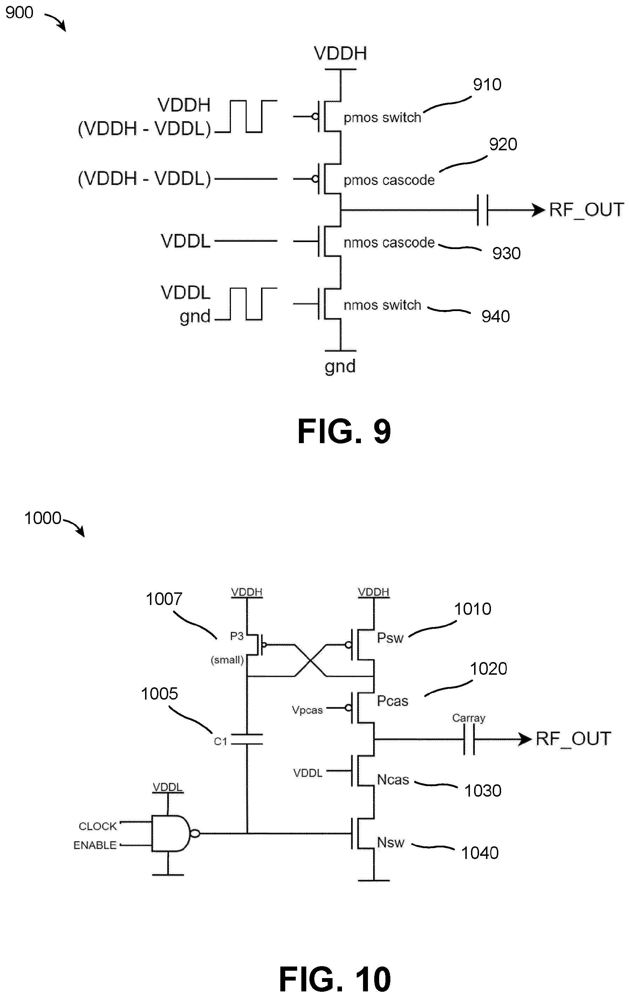

FIG. 9 depicts an example schematic of an example ScPa output switch unit 900, which includes a stack of four core devices as noted above. For example, the ScPa output switch unit 900 includes the two switch devices comprising a PMOS switch 910 and an NMOS switch 940. The ScPa output switch unit 900 further includes the two cascode devices, comprising a PMOS cascode 920 and an NMOS cascode 930. In some examples, the cascode devices may correspond to common-source transistors feeding into common-gate transistors, among various other configurations and/or implementations. In the example schematic of the ScPa output switch unit 900 illustrated in FIG. 9, the IO voltage (VDDH) is set to be a maximum of twice the core voltage (VDDL). The IO voltage (VDDH) can correspond to the high voltage rail driving the ScPa output switch unit 900, and the core voltage (VDDL) can correspond to the low voltage rail of the ScPa output switch unit.

In some examples, the voltages required on each of the device gates included within the ScPa output switch unit 900 are as follows: the NMOS switch device 940 gate is to be driven with a clock between 0 and VDDL; the NMOS cascode 930 gate is to be driven to VDDL; the PMOS cascode 920 gate is to be driven to the difference between the IO voltage and the core voltage (VDDH - VDDL); and the PMOS switch device 910 gate is to be driven with a clock between (VDDH - VDDL) and VDDH.

In an illustrative example, a circuit 1000 that achieves the required voltage on each of the devices included in the stack of the four core devices in the ScPa output unit according to an embodiment of the present invention is shown in FIG. 10. An NMOS switch device 1040 (e.g., "Nsw" in FIG. 10) can be the same as or similar to the NMOS switch device 940 of FIG. 9, and can be driven directly from a core voltage inverter driven from the VDDL rail of the circuit 1000. An NMOS cascode gate 1030 (e.g., "Ncas" in FIG. 10) can be the same as or similar to the NMOS cascode gate 930 of FIG. 9, and can be connected directly to the VDDL rail of the circuit 1000.

The necessary signal voltage shifting for a PMOS switch device 1010 (e.g., "Psw" in FIG. 10, where the PMOS switch device 1010 may be the same as or similar to the PMOS switch device 910 of FIG. 9) can be achieved by using a capacitor 1005 (C1) connected between the NMOS switch 1040 gate and the PMOS switch 1010 gate, where the capacitor 1005 (C1) is charged to have a voltage of (VDDH - VDDL) across the capacitor. No current is required to maintain this voltage difference across the series capacitor, and the power requirement of this level shifter is advantageously no more than would be needed to drive a simple core voltage inverter. A very small cross coupled PMOS device 1007 (P3) may be included in circuit 1000 to periodically top up any small amount of charge that does leak away from the capacitor over time.

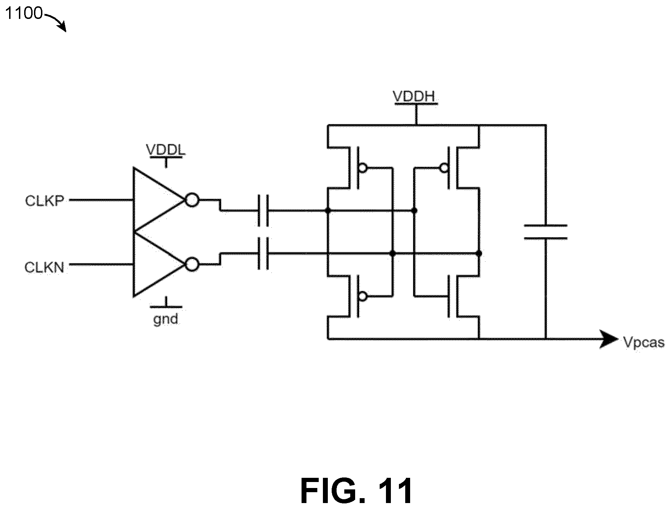

In some embodiments, the PMOS cascode gates (e.g., such as the PMOS cascode 1020 of FIG. 10, "Pcas" in FIG. 10) are biased at a fixed voltage below the VDDH rail by using a charge pump driven by VDDL level clock inputs as shown in the example circuit 1100 of FIG. 11. In the example circuit 1100, the core supply voltage is DC shifted through series capacitors to generate a rail that is one core voltage below the VDDH rail. The DC current taken by the Vpcas rail for the whole ScPa array is small, due only to gate leakage. Embodiments of the charge pump are implemented with very small switches, which takes negligible current to operate.

Advantages of these circuits include decoupling the speed of IO device performance from the circuits operating at the core device speed. For example, the circuits described above and implemented according to aspects of the present invention do not limit the speed by the IO device performance as the circuits operate at the core device speed. There is no power taken from the VDDH rail for signal buffering and level shifting. The switch resistance does not increase when VDDH is reduced, because the Vgs seen for all of the devices remains unchanged. The efficiency thus does not degrade when output power is reduced by dropping rail voltage. In some embodiments, VDDH may be reduced to very low levels (e.g., for example, in at least some cases VDDH may be reduced to be below VDDL), while still maintaining fast operation, good switch resistance, and efficiency, as the disclosed circuits described above enable the PMOS switch gates and the PMOS cascode gates to drop to negative voltages below the ground rail.

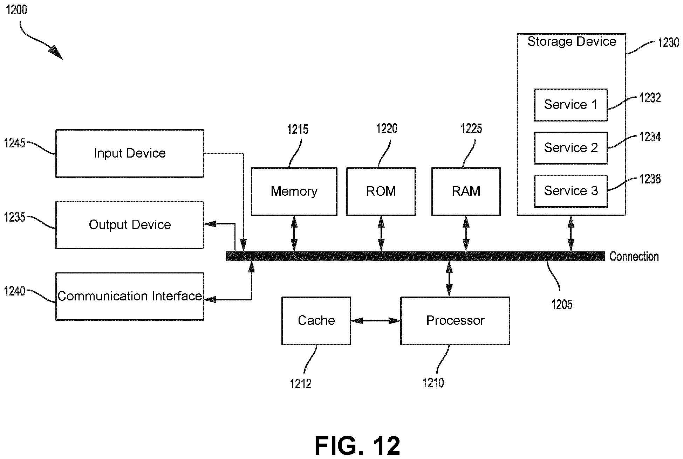

FIG. 12 illustrates a computing device architecture 1200 of a computing device which can implement one or more techniques described herein. In some examples, the computing device can include a mobile device, a wearable device, an extended reality device (e.g., a Virtual Reality (VR) device, an Augmented Reality (AR) device, or a Mixed Reality (MR) device), a personal computer, a laptop computer, a video server, a vehicle (or computing device of a vehicle), or other device. The components of computing device architecture 1200 are shown in electrical communication with each other using connection 1205, such as a bus. The computing device architecture 1200 includes a processing unit 1210 and computing device connection 1205 that couples various computing device components including computing device memory 1215, such as Read Only Memory (ROM) 1220 and Random-Access Memory (RAM) 1225, to processor 1210.

Computing device architecture 1200 can include a cache of high-speed memory connected directly with, in close proximity to, or integrated as part of processor 1210. Computing device architecture 1200 can copy data from memory 1215 and/or the storage device 1230 to cache 1212 for quick access by processor 1210. In this way, the cache can provide a performance boost that avoids processor 1210 delays while waiting for data. These and other engines can control or be configured to control processor 1210 to perform various actions. Other computing device memory 1215 may be available for use as well. Memory 1215 can include multiple different types of memory with different performance characteristics. Processor 1210 can include any general-purpose processor and a hardware or software service, such as service 1 1232, service 2 1234, and service 3 1236 stored in storage device 1230, configured to control processor 1210 as well as a special-purpose processor where software instructions are incorporated into the processor design. Processor 1210 may be a self-contained system, containing multiple cores or processors, a bus, memory controller, cache, etc. A multi-core processor may be symmetric or asymmetric.

To enable user interaction with the computing device architecture 1200, input device 1245 can represent any number of input mechanisms, such as a microphone for speech, a touch-sensitive screen for gesture or graphical input, keyboard, mouse, motion input, speech and so forth. Output device 1235 can also be one or more of a number of output mechanisms known to those of skill in the art, such as a display, projector, television, speaker device, etc. In some instances, multimodal computing devices can enable a user to provide multiple types of input to communicate with computing device architecture 1200. Communication interface 1240 can generally govern and manage the user input and computing device output. There is no restriction on operating on any particular hardware arrangement and therefore the basic features here may easily be substituted for improved hardware or firmware arrangements as they are developed.

Storage device 1230 is a non-volatile memory and can be a hard disk or other types of computer readable media which can store data that are accessible by a computer, such as magnetic cassettes, flash memory cards, solid state memory devices, digital versatile disks, cartridges, RAM, ROM, and hybrids thereof. Storage device 1230 can include services 1232, 1234, 1236 for controlling processor 1210. Other hardware or software modules or engines are contemplated. Storage device 1230 can be connected to the computing device connection 1205. In one aspect, a hardware module that performs a particular function can include the software or processor readable codes stored in a computer-readable medium in connection with the necessary hardware components, such as processor 1210, connection 1205, output device 1235, and so forth, to carry out the function.

The term "device" is not limited to one or a specific number of physical objects (such as one smartphone, one controller, one processing system and so on). As used herein, a device may be any electronic device with one or more parts that may implement at least some portions of this disclosure.

Individual aspects may be described above as a process or method which is depicted as a flowchart or a data flow diagram. Although a flowchart may describe the operations as a sequential process, many of the operations can be performed in parallel or concurrently. In addition, the order of the operations may be re-arranged. A process is terminated when its operations are completed, but could have additional steps not included in a figure. A process may correspond to a method, a function, a procedure, a subroutine, or a subprogram. When a process corresponds to a function, its termination can correspond to a return of the function to the calling function or the main function.

The techniques described herein may also be implemented in electronic hardware, computer software, firmware, or any combination thereof. Such techniques may be implemented in any of a variety of devices such as general purpose computers, wireless communication device handsets, or integrated circuit devices having multiple uses including application in wireless communication device handsets and other devices. Any features described as modules or components may be implemented together in an integrated logic device or separately as discrete but interoperable logic devices. If implemented in software, the techniques may be realized at least in part by a computer-readable data storage medium comprising program code including instructions that, when executed, performs one or more of the methods described above.

The program code may be executed by a processor, which may include one or more processors, such as one or more Digital Signal Processors (DSPs), general purpose microprocessors, an Application Specific Integrated Circuits (ASICs), Field Programmable Gate Arrays (FPGAs), or other equivalent integrated or discrete logic circuitry. Such a processor may be configured to perform any of the techniques described in this disclosure. A general-purpose processor may be a microprocessor; but in the alternative, the processor may be any conventional processor, controller, microcontroller, or state machine. A processor may also be implemented as a combination of computing devices.

**Claims**

1. A switched capacitor power amplifier (ScPa) apparatus comprising:

   a switched capacitor array including a plurality of unit cells shareable between an in-phase (I) component and a quadrature-phase (Q) component of an input radio frequency (RF) signal, wherein each unit cell of the plurality of unit cells comprises a capacitor and an inverter;
   a respective pair of control bits associated with each unit cell of the plurality of unit cells, wherein the respective pair of control bits includes a first control bit configured for selectively enabling or not enabling the unit cell to be driven based on the I component, and a second control bit configured for selectively enabling or not enabling the unit cell to be driven based on the Q component; and
   a truth table logic configured for a first subset of unit cells and a second subset of unit cells of the plurality of unit cells, wherein the truth table logic causes the unit cells of the first subset to be driven based on the I component in response to a double-enabled condition of the respective pair of control bits, and wherein the truth table logic causes the unit cells of the second subset to be driven based on the Q component in response to the double-enabled condition of the respective pair of control bits.

2. The ScPa apparatus of claim 1, wherein the ScPa apparatus implements an analog clipping scheme based on a set of unit cells with the double-enabled condition of the switched capacitor array configured with the truth table logic, and wherein the set of unit cells with the double-enabled condition is included in the plurality of unit cells.

3. The ScPa apparatus of claim 2, wherein the analog clipping scheme implemented using the truth table logic causes a first half of the set of unit cells with the double-enabled condition to be driven by an I clock corresponding to the I component, and causes a second half of the set of unit cells with the double-enabled condition to be driven by a Q clock corresponding to the Q component.

4. The ScPa apparatus of claim 3, wherein the set of unit cells with the double-enabled condition is equal to a difference between a magnitude of the I component summed with a magnitude of the Q component, and a number of the plurality of unit cells included in the switched capacitor array.

5. The ScPa apparatus of any one of claims 1 to 4, wherein the double-enabled condition corresponds to each bit of the respective pair of control bits for a unit cell being set to high, indicative of enabling the unit cell to be driven based on the I component and enabling the unit cell to be driven based on the Q component.

6. The ScPa apparatus of any one of claims 1 to 5, wherein the first subset of unit cells comprises a first half of the plurality of unit cells, and wherein the second subset of unit cells comprises a second half of the plurality of unit cells.

7. The ScPa apparatus of any one of claims 1 to 6, wherein a number of unit cells included in the first subset is equal to a number of unit cells included in the second subset.

8. The ScPa apparatus of any one of claims 1 to 7, wherein one of the first subset and the second subset of unit cells comprises even-indexed unit cells of the switched capacitor array, and another one of the first subset and the second subset of unit cells comprises odd-indexed unit cells of the switched capacitor array.

9. The ScPa apparatus of any one of claims 1 to 8, wherein the truth table logic causes the plurality of unit cells to be driven according to the respective pair of control bits in the absence of the double-enabled condition.

10. The ScPa apparatus of any one of claims 1 to 9, wherein the truth table logic encodes a priority of the I component over the Q component for the first subset of unit cells, and the truth table logic maps the encoded priority of the I component over the Q component to the double-enabled condition where the first and second control bits are each set high for a respective unit cell of the first subset; wherein the truth table logic encodes a priority of the Q component over the I component for the second subset of unit cells, and the truth table logic maps the encoded priority of the Q component over the I component to the double-enabled condition where the first and second control bits are each set high for a respective unit cell of the second subset.

11. The ScPa apparatus of any one of claims 1 to 10, wherein each unit cell of the plurality of unit cells of the switched capacitor array is switchably coupled to a primary input of an inductive transformer or balun included in the ScPa apparatus.

12. The ScPa apparatus of any one of claims 1 to 11, wherein:

the truth table logic causes the ScPa apparatus to automatically implement an analog clipping scheme for IQ amplitude codes having a magnitude sum greater than a number of unit cells included in the plurality of unit cells; and
the analog clipping scheme is implemented locally by each unit cell with the double-enabled condition, according to the configured truth table logic for each unit cell with the double-enabled condition.

13. The ScPa apparatus of any one of claims 1 to 12, further comprising a voltage level shifter in an output switch unit, wherein the output switch unit comprises an NMOS switch device gate, an NMOS cascode gate, a PMOS cascode gate, and a PMOS switch device gate.

14. The ScPa apparatus of claim 13, wherein the NMOS switch device gate is driven from a core voltage inverter driven from a core voltage (VDDL) rail, the NMOS cascode gate is coupled to the VDDL rail, the PMOS cascode gate is biased at a fixed voltage below an IO voltage (VDDH) rail, and the PMOS switch device gate is charged with a voltage of (VDDH - VDDL) by signal voltage shifting using a capacitor between the NMOS switch device gate and the PMOS switch device gate.

15. The ScPa apparatus of claim 14, wherein the IO voltage (VDDH) is set to be a maximum of twice the core voltage (VDDL).

16. The ScPa apparatus of claims 14 or 15, wherein the output switch unit further comprises a cross coupled PMOS device to periodically top up any small amount of charge leaks away from the capacitor over time.

17. The ScPa apparatus of any one of claims 14 to 16, wherein the PMOS cascode gate is coupled to a charge pump driven by VDDL level clock inputs, and a core supply voltage of the charge pump is DC-shifted through series capacitors to generate a rail that is one core voltage below the VDDH rail.

18. A method of controlling a switched capacitor power amplifier (ScPa) with adaptive clipping, comprising:

obtaining in-phase (I) and quadrature-phase (Q) codes corresponding to an input radio frequency (RF) signal;
comparing a sum of absolute values of the I and Q codes with a threshold value, the threshold value corresponding to a number of unit cells included in a plurality of unit cells of a switched capacitor array of the ScPa;
determining each output cell of inverter and capacitor arrays in the ScPa to be an I clock enabled output cell, a Q clock enabled output cell, a double-enabled output cells, or an off output cell according to the I and Q codes, wherein the number of double-enabled output cells is equal to zero when the sum of absolute values of the I and Q codes is less than or equal to the threshold value, and the number of double-enabled output cells is equal to the sum of absolute values of the I and Q codes minus the threshold value;
controlling a half of the double-enabled output cell to be driven by an I clock and controlling another half of the double-enabled output cell to be driven by a Q clock;
controlling the I clock enabled output cells of the inverter and capacitor arrays to be driven by the I clock; and
controlling the Q clock enabled output cells of the inverter and capacitor arrays to be driven by the Q clock.

19. The method of claim 18, wherein controlling the ScPa includes implementing an analog clipping scheme based on configuring a set of unit cells with a double-enabled condition of the switched capacitor array with a truth table logic, and wherein the set of unit cells with the double-enabled condition is included in the plurality of unit cells.

20. The method of claim 19, wherein the truth table logic causes a first half of the set of unit cells with the double-enabled condition to be driven by an I clock corresponding to the I code, and causes a second half of the set of unit cells with the double-enabled condition to be driven by a Q clock corresponding to the Q code.

100

104a    108a    108b    104b

108d    108c

104d    102    104c

110

106

**FIG. 1**

## FIG. 2A

## FIG. 2B

**FIG. 2C**

**FIG. 3**

400

410

Amplitude Code = 0 to 'n/2-1'

402

430

Amplitude Code = 'n/2' to 'n'

404

EN

EN

# FIG. 4

500

510

I Code = 0 to 'n/2-1'
Q Code = 'n' to 'n/2'

502

530

I Code = 'n/2' to 'n'
Q Code = 'n/2-1' to 0

504

EN

EN

# FIG. 5

**FIG. 6**

**FIG. 7**

800

$|I| + |Q| < N$

Example array unit
allocations when not
clipping:

'off' units

| I | | Q |

I code

Q code

850

'double-enabled' Units
(alternating I & Q)

$|I| + |Q| > N$

Example array unit
allocations when clipping:

| I | | Q |

I code

Q code

# FIG. 8

900

VDDH

VDDH
(VDDH - VDDL)

910
pmos switch

(VDDH - VDDL)

920
pmos cascode

RF_OUT

VDDL

nmos cascode

930

VDDL
gnd

nmos switch

940

gnd

# FIG. 9

1000

VDDH          VDDH

1007
P3
(small)

1010
Psw

1020
Pcas

Vpcas

1005
C1

Carray

RF_OUT

VDDL          VDDL

Ncas

1030

CLOCK
ENABLE

Nsw

1040

# FIG. 10

**FIG. 11**

**FIG. 12**

**REFERENCES CITED IN THE DESCRIPTION**

**Patent documents cited in the description**

• AU 2024903101